Europäisches Patentamt

European Patent Office

Office européen des brevets

(11) Veröffentlichungsnummer: **0 250 718**
**A1**

(12) **EUROPÄISCHE PATENTANMELDUNG**

(21) Anmeldenummer: **87104437.6**

(22) Anmeldetag: **25.03.87**

(51) Int. Cl.⁴: **H02M 5/458** , G01N 24/06

(30) Priorität: **30.06.86 DE 3621889**

(43) Veröffentlichungstag der Anmeldung:
**07.01.88 Patentblatt  88/01**

(84) Benannte Vertragsstaaten:
**DE FR GB**

(71) Anmelder: **Siemens Aktiengesellschaft Berlin
und München
Wittelsbacherplatz 2
D-8000 München 2(DE)**

(72) Erfinder: **Müller, Albert, Dipl.-Ing.
Am Erlanger Weg 47c
D-8520 Erlangen(DE)**
Erfinder: **Neuffer, Ingemar, Dipl.-Ing.
Rudelsweiher Strasse 49
D-8520 Erlangen(DE)**

(54) **Stromversorgung für einen induktiven Verbraucher, insbesondere eine Gradientenspule, mit Steuer- und Regeleinrichtung.**

(57) Zur pulsartigen Erzeugung hoher Magnetfelder in induktiven Verbrauchern werden genau definierte Strompulse i $_v$(t) mit hoher Flankensteilheit und hohem Endwert benötigt. Insbesondere in der Kernspintomographie dienen solche Pulse zum Aufbau eines ortsveränderlichen magnetischen Feldes mit möglichst linearem Feldstärkegradienten. Eine Stromversorgung zur Bereitstellung solcher Strompulse besteht aus einer Reihenschaltung eines Spannungsstufenschalters (STS) und einer einstellbaren Spannungsquelle (SQ), deren resultierende Ausgangsspannung zum Auf-bzw. Abbau der einzelnen Pulse vorzeichenrichtig durch einen Spannungsumschalter (SUS) an den induktiven Verbraucher (V) angelegt wird. Eine Schalt-und Regeleinrichtung (SRE) steuert den Stufenschalter, die einstellbare Spannungsquelle und den Spannungsumschalter in Abhängigkeit vorgegebener Sollverläufe der Pulse insbesondere so an, daß diese eine endwertunabhängige Anstiegs-und Abfallzeit haben.

FIG 2

EP 0 250 718 A1

## Stromversorgung für einen induktiven Verbraucher, insbesondere eine Gradientenspule, mit Steuer- und Regeleinrichtung

Die Erfindung bezieht sich auf eine Vorrichtung zur Erzeugung kurzer Strompulse mit hoher Flankensteilheit und großem Endwert für induktive Verbraucher, insbesondere für Gradientenspulen zur Kernspintomographie, bei der zum schnellen Aufbau eines Pulses eine hohe und zu dessen Aufrechterhaltung eine niedrige Verbraucherspannung angelegt wird.

Insbesondere bei bildgebenden Verfahren in der medizinischen Diagnostik werden zur räumlichen Auflösung der vom zu untersuchenden Objekt aufgenommenen Kernresonanzsignale diesem neben einem konstanten Grundmagnetfeld und einem hochfrequenten Wechselfeld zusätzlich in alle drei Raumrichtungen ortsveränderliche Magnetfelder überlagert. Letztere werden auch Gradientenfelder genannt und haben eine in der jeweiligen Richtung möglichst linear zunehmende magnetische Feldstärke. Sie sind Voraussetzung für die Rekonstruktion eines Objektbildes und werden bevorzugt durch hochfrequente Pulsung sogenannter Gradientenspulen erzeugt, was hohe Anforderungen an die zu deren Speisung notwendigen Stromversorgungen zur Folge hat. Diese müssen pulsförmige Ströme mit mehreren 100 A Endwert mit Anstiegszeiten auf-bzw. abbauen, die im Millisekundenbereich liegen.

Bekannte Anordnungen dieser Art bestehen z.B. aus vier in Form einer Brücke angeordneten Leistungstransistoren, in deren Querzweig der induktive Verbraucher angeschlossen ist. Dabei werden bei einer Ausführungsform diese Transistoren als Linearregler mit einem Stellbereich von etwa der Hälfte der gesamten Versorgungsspannung betrieben. Die dabei auftretenden großen Verluste werden noch dadurch erhöht, daß wegen der geringen Strombelastungsfähigkeit jeder der vier Leistungstransistoren der Brücke tatsächlich aus einer Parallelschaltung von etwa 60 realen Transistoren besteht. In einer anderen Ausführungsform werden die Transistoren von einem hochfrequenten, pulsförmigen Signal betrieben, so daß das Verhalten dieser Stromversorgung dem eines Schaltnetzteiles entspricht. Dies hat aber nachteilig einen relativ oberwellenhaltigen Verbraucherstrom zur Folge.

Aus der DE-OS 31 12 280 ist eine weitere Vorrichtung dieser Art bekannt. Bei dieser wird zum Aufbau eines pulsförmigen Stromes beliebigen Vorzeichens zunächst eine hohe, konstante Spannung an den induktiven Verbraucher angelegt. Nach Erreichen einer gewünschten Pulshöhe wird auf eine niedrigere Versorgungsspannung umgeschaltet, die zu deren Aufrechterhaltung ausreichend ist, und die Stromstärke über eine Regeleinrichtung durch Verändern der auf den Verbraucher einwirkenden Spannung konstant gehalten. Zum Abbau der jeweiligen Strompulse dienen Freilaufkreise, die zum Teil durch Einschalten zusätzlicher elektronischer Ventile geschlossen werden und unter Umständen eine Rückspeisung der im induktiven Verbraucher enthaltenen Energie in eine der beiden Spannungsquellen ermöglichen.

Der Erfindung liegt die Aufgabe zugrunde, eine mit vertretbarem wirtschaftlichen Aufwand zu realisierende Vorrichtung zur hochgenauen und verlustarmen Erzeugung genau definierter Strompulse, insbesondere mit vorgegebener hoher Flankensteilheit und großem Endwert, zur Speisung von induktiven Verbrauchern anzugeben. Die geforderten Strompulse können dabei unregelmäßig aufeinander folgen und insbesondere unterschiedliche Endwerte haben. Ferner kann den Strompulsen eine vom jeweiligen Endwert unabhängige konstante Anstiegs-bzw. Abfallzeit vorgegeben werden.

Die Aufgabe der Erfindung wird gelöst durch eine Vorrichtung, die aus einem Stufenschalter zur Voreinstellung des Betrages der jeweiligen Verbraucherspannung, aus einer einstellbaren Spannungsquelle in Reihe zu Stufenschalter und Verbraucher zur Feineinstellung des Betrages der Verbraucherspannung, aus einem Spannungsumschalter, durch den die jeweilige Verbraucherspannung in ihrem Vorzeichen so an den Verbraucher angelegt wird, daß die einzelnen Strompulse schnell auf-bzw. abgebaut werden, und aus einer Schalt-und Regeleinrichtung, welche abhängig vom Endwert,der Flankensteilheit und dem Vorzeichen der Pulse den Stufenschalter, die regelbare Spannungsquelle und den Spannungsumschalter ansteuert, besteht. Dabei besteht der Stufenschalter insbesondere aus in Reihe angeordneten Gruppen untereinander gleicher Spannungsquellen und einem daran angeschlossenen Schalternetzwerk.

Eine Steuer-und Regeleinrichtung besteht bevorzugt aus einem Streckenmodell, das entsprechend dem Lastwiderstand $R_V$ und der Lastinduktivität $L_V$ aus der vorgegebenen Form $i_V^*(t)$ des jeweiligen Strompulses den Sollwert $U_V^*$ der Verbraucherspannung nach der Gleichung

$$U_V^* = R_V \cdot i_V^*(t) + L_V \cdot \frac{d\ i_V^*(t)}{dt}$$

vorsteuert. Ferner enthält sie insbesondere einen Analog-Digital-Wandler, der den Sollwert der Verbraucherspannung in eine binäre Zahl umsetzt und einen Decoder, der den Stufenschalter entsprechend dem Betrag der binären Zahl zur Voreinstellung der Verbraucherspannung und den Spannungsumschalter entsprechend dem Vorzeichen der binären Zahl zum vorzeichenrichtigen Anlegen der Verbraucherspannung ansteuert.

Schließlich enthält die Steuer-und Regeleinrichtung bevorzugt einen Spannungsregler, der die einstellbare Spannungsquelle abhängig von der Differenz aus Ausgangsspannung des Stufenschalters und dem Betrag des Sollwertes der Verbraucherspannung, und abhängig von der Abweichung dieser Differenz von der Ausgangsspannung der einstellbaren Spannungsquelle ansteuert.

Es ist besonders vorteilhaft, wenn in der Steuer-und Regeleinrichtung ein zusätzlicher Verbraucherstromregler aus der Regelabweichung von Verbraucherstromist-und Sollwert ein Korrektursignal bildet und dem Sollwert der Verbraucherspannung aufschaltet. Bei einem weiteren bevorzugt angewendeten Pulsgeber, bei dem durch einen Sollwertgeber Endwerte, Anstiegs-und Abfallzeitpunkte der Strompulse vorgegeben werden, wird bei jedem Pulsanstieg bzw. -abfall ein normierter Hochlaufgeber mit einstellbarer Integrierzeit gestartet und nach Multiplikation der Integriererausgangs-und Eingangsgrößen mit den jeweiligen Endwerten der Sollverlauf der einzelnen Strompulse und deren Ableitungen als Kenngrößen ausgegeben. Der normierte Hochlaufgeber enthält insbesondere einen von einem Komparator angesteuerten und an dessen Eingang gegengekoppelten Integrierer. Eine zusätzliche Einrichtung zur Wirbelstromkompensation besteht vorteilhaft aus einer von den zu berücksichtigenden Wirbelstromzeitkonstanten abhängigen Anzahl paralleler Übertragungsglieder mit differenzierend-verzögerndem Verhalten. Diese schalten ein vom Sollverlauf des jeweiligen Strompulses abhängiges Ausgangssummensignal der Regelabweichung des Verbraucherstromreglers auf. Es ist weiterhin besonders vorteilhaft, wenn die Schalt-und Regeleinrichtung eine Einrichtung zur Netzkompensation enthält. Bei dieser wird bei Über-bzw. Unterschreiten eines Maximal-bzw. Minimalwertes des Sollwertes des Spannungsreglers ein binärer Zähler herunter-bzw. hochgezählt und dessen Inhalt der binären Zahl aufaddiert. Schließlich wird insbesondere der Regelabweichung des Verbraucherstromreglers ein in einem Sollwertgeber gebildeter Wert als Ersatz für den Einfluß von ansonsten zusätzlich am induktiven Verbraucher angebrachten Shim-Spulen aufgeschaltet.

Der Spannungsumschalter der erfindungsgemäßen Vorrichtung besteht bevorzugt aus vier in Form einer Brücke angeordneten Schaltern, wobei der Verbraucher in deren Querzweig angeordnet ist. Dabei besteht jeder der vier Schalter bevorzugt aus einem Schalttransistor mit antiparalleler Freilaufdiode.

Die Spannungswerte der Gruppen untereinander gleicher Spannungsquellen des Stufenschalters sind insbesondere so abgestuft, daß der Spannungswert jeder Quelle einer folgenden Gruppe der um den Spannungswert einer Quelle der vorangehenden Gruppe erhöhten Summe aller Spannungswerte dieser Gruppe entspricht. Dabei ist es besonders vorteilhaft, wenn die kleinste Wertigkeit der binären Zahl der kleinsten vom Stufenschalter vorgebbaren Spannung, und die an der einstellbaren Spannungsquelle maximal vorgebbare Spannung der kleinsten vom Stufenschalter vorgebbaren Spannung entspricht. Die einstellbare Spannungsquelle selbst besteht insbesondere aus einer Diodenbrücke, bei der ein Transistor mit linear aussteuerbarer Kollektor-Emitter-Spannung im Querzweig angeordnet ist.

Die Schalter des Stufenschalters sind bevorzugt ausgeführt als zwei antiparallele Transistoren mit je einer in Kollektor-Emitter-Richtung angeordeten Reihendiode. Schließlich ist es besonders vorteilhaft, wenn am Ausgang des Stufenschalters eine Schutzdiode in Sperrichtung angeordnet ist.

Anhand der nachfolgend kurz angeführten Figuren wird die Erfindung näher erläutert. Dabei zeigt

Figur 1 skizzenhaft eine Zusammenstellung der möglichen Pulsformen des Verbraucherstromes,

Figur 2 ein Prinzipschaltbild der erfindungsgemäßen Vorrichtung,

Figur 3 ein bevorzugtes Ausführungsbeispiel der erfindungsgemäßen Vorrichtung, und

Figur 4 eine besonders geeignete Ausführungsform der erfindungsgemäßen Schalt-und Regeleinrichtung.

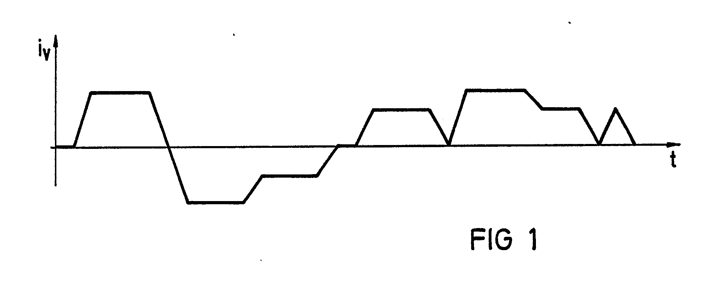

Die insbesondere zur Speisung von Gradientenspulen geforderten möglichen Formen der Verbraucherstrompulse $i_V(t)$ sind skizzenhaft in der Figur 1 zusammengestellt. So können Strompulse mit und ohne Pause auch mit wechselndem Vorzeichen aufeinander folgen. Ferner sind Amplitudenänderungen ohne zwischenzeitlichen Rückgang des Stromes auf den Wert Null möglich. Im Grenzfall kann ein Impuls auch zu einem Stromanstieg mit unmittelbar darauf folgendem Abfall entarten. Eine zusätzliche Anforderung an die Pulsform kann darin bestehen, daß alle Pulse unabhängig von ihrem aktuellen Endwert eine konstante, vorgebbare Anstiegs-bzw. Abfallzeit haben. Dies ist bereits in der Darstellung der Figur 1 berücksichtigt.

Zum Aufbau von Spulenfeldern mit Feldstärkegradienten von ca. 10 mT/m bedingt diese Vielfalt an möglichen Pulsformen und die Anforderungen an deren Reproduzierbarkeit einen hohen gerätetechnischen Aufwand der dazu erforderlichen Stromversorgung, insbesondere auch wegen deren großem Spannungs-Stellbereich und der geforderten Stromänderungsgeschwindigkeiten. So können Spitzenströme bis über 500 A und Dauerströme zwischen 300 bis 400 A auftreten, die in weniger als einer Millisekunde auf-bzw. abgebaut werden müssen. Die möglichen Dauern der Strompulse liegen dabei im Bereich zwischen 2 und 100 ms, und die zulässige Abweichung von deren Sollverlauf bei weniger als 0,4 %.

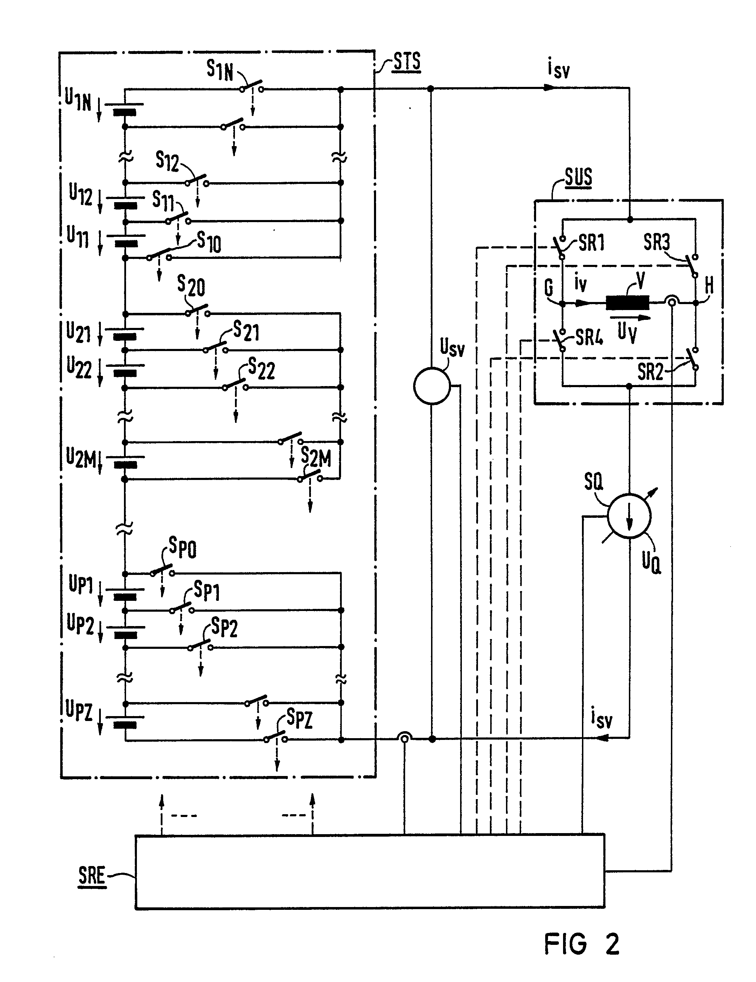

Die erfindungsgemäße Stromversorgung kann bei geeigneter Auslegung obige Spezifikationen mit vertretbarem gerätetechnischem Aufwand erfüllen, und wird im folgenden anhand der Figuren 2 bis 4 näher erläutert.

Zur schnellen und verlustarmen Einstellung der zum Aufbau, der Aufrechterhaltung und dem Abbau der gewünschten Strompulse $i_V(t)$ notwendigen Spannung $U_V$ am induktiven Verbraucher V dienen erfindungsgemäß ein sogenannter "Stufenschalter" STS und eine einstellbare Spannungsquelle SQ, wie sie im Prinzipschaltbild der Figur 2 dargestellt sind. Dabei besteht der Stufenschalter STS bevorzugt aus in Reihe angeordneten Gruppen von Spannungsquellen $U_{11}$ ... $U_{1N}$, $U_{21}$ ... $U_{2M}$ bis $U_{P1}$ ... $U_{PZ}$, wobei die Ausgangsspannungen aller Quellen einer jeden Gruppe gleichen Betrag haben. Ein daran angeschlossenes Schalter-netzwerk aus den Schaltergruppen $S_{10}$ ... $S_{1N}$, $S_{20}$ ... $S_{2M}$ bis $S_{PO}$ ... $S_{PZ}$ wird durch eine Schalt-und Regeleinrichtung SRE so angesteuert, daß die zum Auf-/Abbau bzw. der Aufrechterhaltung des jeweiligen Verbaucherstrompulses notwendige Verbraucherspannung $U_V$ durch Hintereinanderschaltung einer geeigneten Kombination von Spannungsquellen möglichst genau voreingestellt wird. Zur Feineinstellung des genauen Betrages der Verbraucherspannung $U_V$ wird die einstellbare Spannungsquelle SQ abhängig von der Ausgangsspannung $U_{SV}$ des Stufenschalters STS ebenfalls von der Schalt-und Regeleinrichtung angesteuert. Damit kann die gewünschte Verbraucherspannung nicht nur sehr schnell und genau eingestellt werden, sondern die auftretenden Verluste, insbesondere in der einstellbaren Spannungsquelle, sind wegen des dort relativ kleinen Spannungsstellbereiches minimal. Entgegen den bekannten Ausführungen in Form von Schaltnetzteilen bzw. Brückenschaltungen mit Linearreglern, die den gesamten Spannungsstellbereich kontinuierlich beeinflussen, ermöglicht die erfindungsgemäße Vorgabe der den Spulenstrom $i_V$ treibenden Verbraucherspannung $U_V$ eine besonders oberwellen-und verlustarme Speisung induktiver Verbraucher. Dies wird insbesondere auch dadurch begünstigt, daß im Stufenschalter Spannungsquellen je nach Bedarf unterbrechungsfrei zu-bzw. abgeschaltet werden können.

So muß die treibende Verbraucherspannung nun lediglich vorzeichenrichtig an den Verbraucher V angelegt werden, um einen Strompuls mit dem gewünschten Vorzeichen aufzubauen, aufrechtzuerhalten bzw. wieder abzubauen. Hierzu dient ein in Figur 2 dargestellter Spannungsumschalter SUS aus bevorzugt vier in Form einer Brücke angeordneten Schaltern SR1 bis SR4, bei dem der Verbraucher im Querzweig zwischen den Knotenpunkten G und H angeschlossen ist. Die Verbraucherspannung wird durch paarweises Betätigen der Schalter SR1, SR2 bzw. SR3, SR4 über die Steuer-und Regeleinrichtung so an den Verbraucher angelegt, daß der über ein Meßglied erfaßte Istwert des Verbraucherstromes $i_V$ einem gewünschten Sollverlauf $i_V*(t)$ folgt.

Dieser erfindungsgemäße Aufbau der Stromversorgung hat den besonderen Vorteil, daß die Spannungsquellen des Stufenschalters zur Speisung weiterer, bevorzugt identisch aufgebauter Stromversorgungen verwendet werden können. So kommen insbesondere bei der Kernspintomographie die zum Aufbau der drei Gradientenfelder für alle Raumrichtungen benötigten drei Stromversorgungen mit einem einzigen Satz gruppenweise in Reihe angeordneter Spannungsquellen aus.

Die Spannungswerte der Quellen der einzelnen Gruppen und damit die Gesamtanzahl an Spannungsquellen im Stufenschalter werden dabei im Hinblick auf den Wert der am induktiven Verbraucher maximal benötigten Verbraucherspannung und zum Beispiel zur Erzielung einer möglichst minimalen Stufenhöhe bzw. Anzahl an Quellen anwendungsspezifisch ausgewählt. Besonders vorteilhaft ist es, wenn die Werte der Ausgangsspannungen der Gruppen der Quellen untereinander so abgestuft sind, daß der Spannungswert einer in der Reihenschaltung folgenden Gruppe der um eins erhöhten Summe aller Spannungswerte der vorangehenden Gruppe entspricht. Der maximale Stellbereich der einstellbaren Spannungsquelle SQ entspricht dabei bevorzugt dem Spannungswert einer der Quellen einer Gruppe bzw. ist zum Erzielen eines sprunglosen Gesamt-Stellbereiches minimal zu diesem versetzt. Es ist dabei insbesondere im Hinblick auf die Verluste besonders vorteilhaft, wenn dieser Stellbereich gerade dem Spannungswert der Gruppe entspricht, die von allen Gruppen den kleinsten Betrag hat.

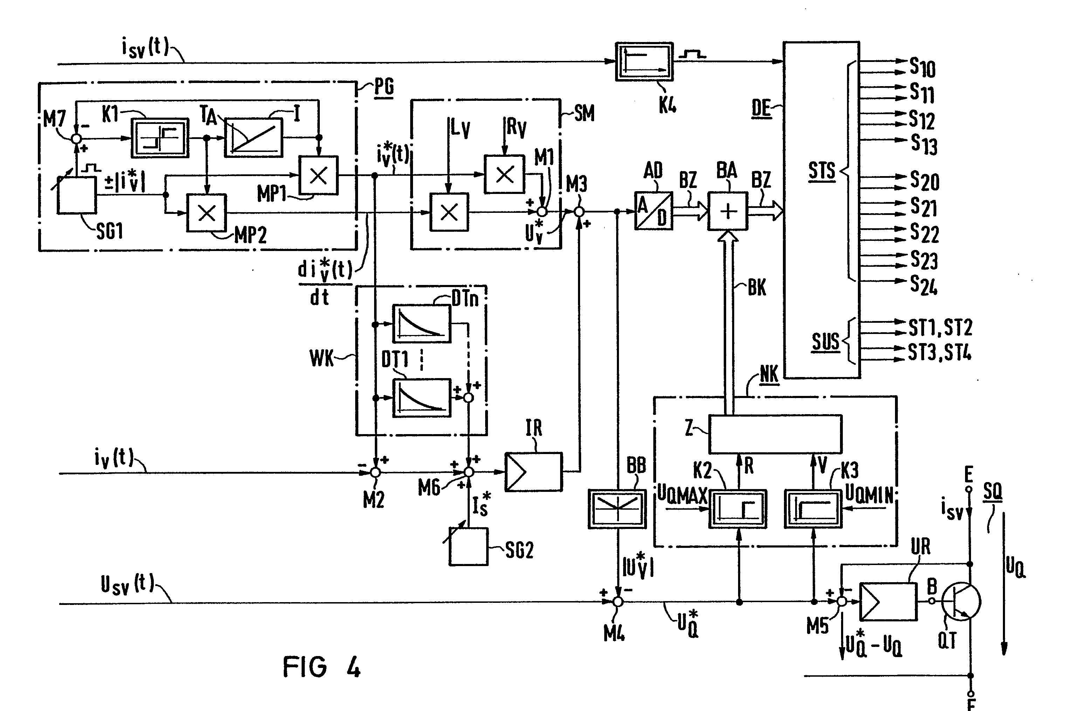

Eine bevorzugte Schalt-und Regeleinrichtung zum Betreiben der erfindungsgemäßen Stromversorgung nach Figur 2 besteht aus einem Streckenmodell SM, einem Analog-Digital-Wandler AD, einem Decoder DE und einem Spannungsregler UR. Diese Elemente sind u.a. in Figur 4 dargestellt. Der Sollverlauf eines gewünschten Strompulses wird in Form der Signale $i_V^*(t)$ und deren Ableitung $di_V^*(t)/dt$ dem Streckenmodell vorgegeben, daß die zum Treiben des Pulses notwendige Spannung $U_V^*$ am Verbraucher V nach der Gleichung

$$U_V^* = R_V \cdot i_V^*(t) + L_V \cdot \frac{di_V^*(t)}{dt}$$

ermittelt. Diese stellt den bekannten Zusammenhang zwischen Spannung und Strom an einer realen Spule der Induktivität $L_V$ und dem ohmschen Widerstand $R_V$ dar. Der so ermittelte Verbraucherspannungssollwert wird durch Ansteuern des Stufenschalters STS und des Spannungsumschalters SUS über den vom Analog-Digital-Wandler AD versorgten Decoder DE und durch Ansteuern der einstellbaren Spannungsquelle SQ über den Spannungsregler UR eingestellt. Hierzu wird der Sollwert im Analog-Digital-Wandler in eine binäre Zahl BZ ·umgewandelt. Mit deren Hilfe werden über den Decoder DE die entsprechenden Schalter des Schalternetzwerkes im Stufenschalter und die entsprechenden Schalterpaare im Spannungsumschalter ausgewählt. Bei geeigneter Codierung der binären Zahl und einer dieser angepaßten Anzahl und Abstufung der Spannungsquellen im Stufenschalter können die Schalter des Schalternetzwerkes und deren Schaltzustände beinahe unmittelbar den einzelnen Stellen der binären Zahl zugeordnet werden. Es ist dabei besonders vorteilhaft, wenn deren kleinste Wertigkeit gerade der kleinsten vom Stufenschalter vorgebbaren Spannung, und diese wiederum der über die einstellbare Spannungsquelle maximal vorgebbaren Spannung $U_Q$ entspricht. Prinzipiell ist es auch denkbar, den Spannungssollwert $U_V^*$ als Zahl eines beliebigen Zahlensystems darzustellen. Schließlich wird zur Feineinstellung des genauen Wertes der Verbraucherspannung durch Subtraktion der Ausgangsspannung $U_{SV}$ des Stufenschalters von dem über das Element BB gebildeten Betrag $|U_V^*|$ des Sollwertes der Verbraucherspannung der Sollwert $U_Q^*$ für den Spannungsregler UR gebildet, der die einstellbare Spannungsquelle SQ entsprechend seiner Regelabweichung ansteuert.

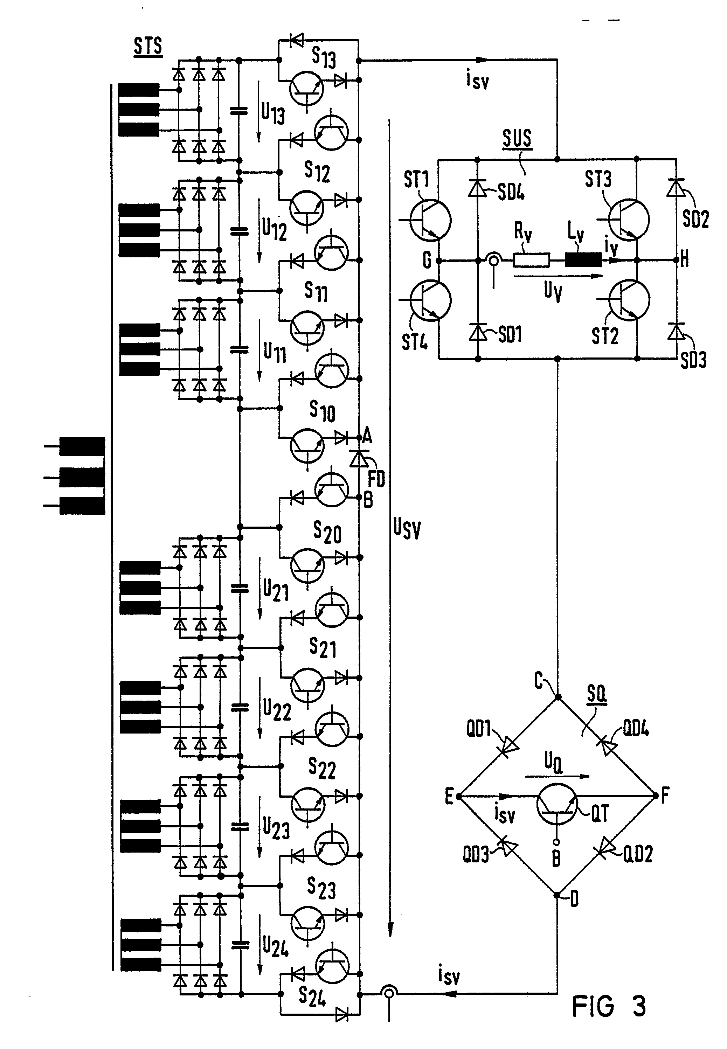

In Figur 3 ist ein bevorzugt verwendetes Ausführungsbeispiel der erfindungsgemäßen Stromversorgung nach Figur 2 dargestellt. Dabei sind speziell zwei Gruppen mit jeweils drei bzw. vier untereinander gleichen Spannungsquellen $U_{11}$ ... $U_{13}$ bzw. $U_{21}$ ... $U_{24}$ im Stufenschalter STS vorhanden, die z.B. die·Spannungswerte 20 V und 80 V haben können. Die Spannungsquellen selbst entsprechen den Sekundärwicklungen eines Drehstromtransformators, die mit je einem ungesteuerten dreiphasigen Gleichrichter und einem Stützkondensator abgeschlossen sind. Die Schalter des Stufenschalters sind insbesondere ausgeführt als Gegenparallelschaltung je eines Schalttransistors mit je einer in Kollektor-Emitter-Stromdurchlaßrichtung angeordneten Reihendiode zum Schutz vor negativen Kollektor-Emitter-Spannungen. Dies hat den besonderen Vorteil, daß bei Zuschaltung einer weiteren Spannungsquelle, z.B. innerhalb einer Gruppe, der Strom $i_{SV}$ sofort auf den Transistor des dazu gehörigen Schalters kommutiert, während der bisher stromführende Transistor über seine Reihendiode abgekoppelt ist. Schließlich ist es besonders vorteilhaft, wenn zur Vermeidung unzulässig hoher Spannungen im Fehlerfalle am Ausgang des Stufenschalters entgegen der Spannung $U_{SV}$eine Schutzdiode FD in Sperrichtung angeordnet ist. Im Ausführungsbeispiel der Figur 3 ist diese an den Knotenpunkten A und B angeschlossen. Sie dient auch als Frei lauf, wenn im Stufenschalter selbst kein Strompfad vorhanden ist.

Die einstellbare Spannungsquelle SQ besteht gemäß Figur 3 vorteilhaft aus einem als Linearregler betriebenen Leistungstransistor QT, dessen Ausgangsspannung $U_Q$ über den Spannungsregelkreis mit dem Spannungsregler UR kontinuierlich in Abhängigkeit der Kollektor-Emitter-Spannung $U_Q$ eingestellt wird. Dieser Linearregler ist zudem im Querzweig mit den Eckpunkten E und F einer Diodenbrücke aus den vier Dioden QD1 bis QD4 angeordnet, damit ein Stromfluß $i_{SV}$ in beiden Richtungen möglich ist. Die Verbraucherspannung $U_V$ ergibt sich unter Anwendung der Maschenregel als Resultierende aus der Spannung des Stufenschalters $U_{SV}$ und der einstellbaren Spannungsquelle $U_Q$ abhängig von der aktuellen Richtung des Stromes $i_{SV}$. Diese wird vom Spannungsumschalter SUS, dessen vier Schalter bevorzugt aus Schalttransistoren ST1 bis ST4 mit je einer antiparallelen Freilaufdiode SD4 bis SD1 bestehen, vorzeichenrichtig an den aus einem Ersatzwiderstand $R_V$ und eine Ersatzinduktivität $L_V$ bestehenden Verbraucher V angelegt.

Es ist besonders vorteilhaft, die Steuer-und Regeleinrichtung SRE um weitere Komponenten zu erweitern. Diese sind insbesondere ein Pulsgeber PG, ein Verbraucherstromregler IR, je eine Einrichtung zur Wirbelstrom-und Netzkompensation WK und NK, und ein zusätzlicher Sollwertgeber SG2. Diese Elemente werden im folgenden anhand der Figur 4 näher erläutert.

Der erfindungsgemäße Pulsgeber PG ermöglicht die Vorgabe genau definierter Verbraucherstrompulse $i_V^*(t)$. Hierzu gibt ein Sollwertgeber SG1 die gewünschten Anstiegs-und Abfallzeitpunkte über ein logisches Rechtecksignal und die gewünschten Endwerte $\pm|i_V^*(t)|$ der einzelnen Pulse vor. Das Rechtecksignal steuert über eine Mischungsstelle M7 einen normierten Hochlaufgeber an, der aus einem von einem Komparator K1 angesteuerten und an dessen Eingang rückgekoppelten Integrierer I mit einstellbarer Integrierzeit $T_A$ besteht. Das normierte Ausgangssignal des Integrierers wird in einem Multiplizierer MP1 mit dem aktuellen Endwert bewertet, so daß sich Strompulse mit vom Endwert unabhängiger Anstiegs-bzw. Abfallzeit ergeben. Es ist besonders vorteilhaft, wenn zur Ansteuerung des Streckenmodells SM zusätzlich das Signal am Eingang des Integrierers über einen zweiten Multiplizierer MP2 ebenfalls mit dem Endwert bewertet und zur weiteren Multiplikation mit der Lastinduktivität $L_V$ ausgegeben wird.

Zur Beseitigung eventueller Ungenauigkeiten des Streckenmodells SM kann dessen Ausgangssignal $U_V^*$ bevorzugt ein Korrektursignal an der Mischungsstelle M3 aufgeschaltet werden. Dieses wird von einem zusätzlichen Verbraucherstromregler IR aus der Regelabweichung von Verbraucherstromist-und sollwert gebildet.

Eine weitere Vorrichtung bildet aus dem Verbraucherstromsollverlauf $i_V^*(t)$ ein weiteres Korrektursignal und schaltet dies der Regelabweichung am Eingang des Verbraucherstromreglers IR auf. Diese zur Wirbelstromkompensation vorgesehene Einrichtung WK berücksichtigt den dämpfenden Einfluß von Wirbelströmen, die bei der schnellen Änderung großer Magnetfelder auftreten. Entsprechend der Anzahl der zu kompensierenden Wirbelstromzeitkonstanten werden Übertragungsglieder DT1 ... DTn mit differenzierend-verzögerndem Verhalten parallelgeschaltet, deren Ausgangssignale aufsummiert und in einer zusätzlichen Mischungsstelle M6 am Eingang des Reglers IR aufgeschaltet.

Zur Homogenisierung des Magnetfeldes im Inneren großer Spulen werden häufig zusätzlich kleine Korrekturspulen, Shim-Spulen genannt, von außen angebracht. Sie können entfallen, wenn deren Einfluß auf das Magnetfeld besonders vorteilhaft mit einem, von einem weiteren Sollwertgeber SG2 gebildeten, sogenannten "Shim-Sollwert" berücksichtigt wird. Dieser wird bevorzugt ebenfalls dem Eingang des Verbraucherstromreglers IR an der Mischungsstelle M6 aufgeschaltet.

Schließlich können plötzliche Netzspannungsschwankungen zu erheblichen Veränderungen der Spannungswerte der Quellen des Stufenschalters STS führen. In einem solchen Fall können am Eingang des Spannungsreglers UR Sollwerte $U_Q^*$ entstehen, die zu einer Über-bzw. Unterschreitung des möglichen Stellbereiches der einstellbaren Spannungsquelle SQ führen würden. So ist es vorteilhaft, bei Über-bzw. Unterschreiten von Maximal-bzw. Minimalwerten $U_{QMAX}$ bzw. $U_{QMIN}$ des Sollwertes $U_Q^*$ einen Zähler Z zurück-bzw. hinaufzuzählen. In einem Addierer BA wird die binäre Zahl BZ um das Ausgangssignal des Zählers Z erhöht, so daß z.B. bei einem Netzspannungseinbruch zusätzliche Spannungsquellen des Stufenschalters zur Stützung der Ausgangsspannung $U_{SV}$ soweit vorhanden zugeschaltet, bzw. bei Netzüberspannungen abgeschaltet werden.

Der Decoder DE hat bei Schaltern des Stufenschalters STS, die entsprechend der Figur 3 als Gegenparallelschaltung von Transistoren ausgeführt sind, die zusätzliche Aufgabe, entsprechend dem aktuellen Vorzeichen des Stromes $i_{SV}(t)$ den jeweils in Stromflußrichtung liegenden Transistor des entsprechenden Schalters anzusteuern. Hierzu wird gemäß Figur 4 das Vorzeichen des Stromes $i_{SV}$ über einen Komparator K4 erfaßt und eines der beiden vom Decoderausgang zu jedem Schalter $S_{10}$ ... $S_{24}$ der Figur 3 führenden Signale aktiviert.

**Ansprüche**

1. Vorrichtung zur Erzeugung kurzer Strompulse mit hoher Flankensteilheit und großem Endwert für induktive Verbraucher, insbesondere für Gradientenspulen zur Kernspintomographie, bei der zum schnellen Aufbau eines Pulses eine hohe und zu dessen Aufrechterhaltung eine niedrige Verbraucherspannung angelegt wird, **gekennzeichnet durch**

a) einen Stufenschalter (STS) zur Voreinstellung des Betrages der jeweiligen Verbraucherspannung ($U_V$),

b) eine einstellbare Spannungsquelle (SQ) in Reihe zu Stufenschalter (STS) und Verbraucher (V) zur Feineinstellung des Betrages der Verbraucherspannung ($U_V$),

c) einen Spannungsumschalter (SUS), durch den die jeweilige Verbraucherspannung in ihrem Vorzeichen so an den Verbraucher angelegt wird, daß die einzelnen Strompulse schnell auf-bzw. abgebaut werden, und

d) eine Schalt-und Regeleinrichtung (SRE), welche abhängig vom Endwert, der Flankensteilheit und dem Vorzeichen der Pulse den Stufenschalter, die regelbare Spannungsquelle und den Spannungsumschalter ansteuert.

2. Vorrichtung nach Anspruch 1 , **dadurch gekennzeichnet,** daß der Stufenschalter (STS) aus in Reihe angeordneten Gruppen untereinander gleicher Spannungsquellen ($U_{11}$ ... $U_{1N}$, $U_{21}$ ... $U_{2M}$, ..., $U_{P1}$ ... $U_{PZ}$) und einem daran angeschlossenen Schalternetzwerk ($S_{10}$ ... $S_{1N}$, $S_{20}$ ... $S_{2M}$, ..., $S_{PO}$ ... $S_{PZ}$) besteht.

3. Vorrichtung nach einem der vorangegangenen Ansprüche, **gekennzeichnet durch** eine Steuer-und Regeleinrichtung (SRE) aus

a) einem Streckenmodell (SM), das entsprechend dem Lastwiderstand $R_V$ und der Lastinduktivität $L_V$ aus der vorgegebenen Form $i_V^*(t)$ des jeweiligen Strompulses den Sollwert $U_V^*$ der Verbraucherspannung nach der Gleichung

$$U_V^* = R_V \cdot i_V^* (t) + L_V \cdot \frac{d\, i_V^* (t)}{dt}$$

vorsteuert,

b) einem Analog-Digital-Wandler (AD), der den Sollwert der Verbraucherspannung ($U_V^*$) in eine binäre Zahl (BZ) umsetzt,

c) einem Decoder (DE), der den Stufenschalter (STS) entsprechend dem Betrag der binären Zahl (BZ) zur Voreinstellung der Verbraucherspannung und den Spannungsumschalter (SUS) entsprechend dem Vorzeichen der binären Zahl zum vorzeichenrichtigen Anlegen der Verbraucherspannung ansteuert, und

d) einen Spannungsregler (UR), der die einstellbare Spannungsquelle (SQ) abhängig von der Differenz aus Ausgangsspannung des Stufenschalters ($U_{SV}$ (t)) und dem Betrag (BB) des Sollwertes der Verbraucherspannung ($|U_V^*|$), und abhängig von der Abweichung dieser Differenz von der Ausgangsspannung ($U_Q$) der einstellbaren Spannungsquelle ansteuert.

4. Vorrichtung nach Anspruch 3 , **gekennzeichnet durch** einen Verbraucherstromregler (IR), der aus der Regelabweichung von Verbraucherstrom-Ist-und Sollwert ein Korrektursignal bildet und dem Sollwert der Verbraucherspannung ($U_V^*$) aufschaltet (M3).

5. Vorrichtung nach Anspruch 3 oder 4 , **gekennzeichnet durch** einen Pulsgeber (PG), bei dem durch einen Sollwertgeber (SG1) Endwerte ($\pm|i_V^*|$), Anstiegs-und Abfallzeitpunkte der Strompulse vorgegeben werden, bei jedem Pulsanstieg bzw. -abfall ein normierter Hochlaufgeber mit einstellbarer Integrierzeit ($T_A$), enthaltend einen von einem Komparator (K1) angesteuerten und an dessen Eingang (M7) gegengekoppelten Integrierer (I), startet und nach Multiplikation der Integriererausgangs-und -eingangsgrößen (MP1, MP2) mit den jeweiligen Endwerten der Sollverlauf der einzelnen Strompulse ($i_V^*(t)$) und deren Ableitungen ($d i_V^*(t) / dt$) als Kenngrößen ausgegeben werden.

6. Vorrichtung nach Anspruch 4 oder 5 , **gekennzeichnet durch** eine Einrichtung zur Wirbelstromkompensation (WK) aus einer von den zu berücksichtigenden Wirbelstromzeitkonstanten abhängigen Anzahl paralleler Übertragungsglieder mit differenzierend-verzögerndem Verhalten ($DT_1$ ... $DT_n$), welche ein vom Sollverlauf des jeweiligen Strompulses ($i_V^*(t)$) abhängiges Ausgangssummensignal der Regelabweichung des Verbraucherstromreglers (IR) aufschalten.

7. Vorrichtung nach einem der Ansprüche 3 bis 6 , **gekennzeichnet durch** eine Einrichtung zur Netzkompensation (NK), bei der bei Über-bzw. Unterschreiten eines Maximal-bzw. Minimalwertes (K2, K3) des Sollwertes ($U_Q^*$) des Spannungsreglers (UR) ein binärer Zähler (Z) herunter-bzw. hochgezählt und dessen Inhalt der binären Zahl (BZ) aufaddiert wird (BA).

8. Vorrichtung nach einem der Ansprüche 4 bis 7 , **dadurch gekennzeichnet,** daß der Regelabweichung des Verbraucherstromreglers (IR) ein in einem Sollwertgeber (SG2) gebildeter Wert als Ersatz für den Einfluß von ansonsten zusätzlich am induktiven Verbraucher angebrachten Shim-Spulen aufgeschaltet wird.

9. Vorrichtung nach einem der vorangegangenen Ansprüche, **dadurch gekennzeichnet,** daß der Spannungsumschalter (SUS) aus vier in Form einer Brücke angeordneten Schaltern (SR1 ... SR4) besteht, wobei der Verbraucher (V) in deren Querzweig (GH) angeordnet ist.

10. Vorrichtung nach Anspruch 9 , **dadurch gekennzeichnet,** daß jeder der vier Schalter des Spannungsumschalters (SUS) aus einem Schalttransistor (ST1 ... ST4) mit antiparalleler Freilaufdiode (SD4 ... SD1) besteht.

11. Vorrichtung nach einem der Ansprüche 2 bis 10 , **dadurch gekennzeichnet,** daß die Spannungswerte der Gruppen untereinander gleicher Spannungsquellen des Stufenschalters (STS) so abgestuft sind, daß der Spannungswert jeder Quelle einer folgenden Gruppe der um den Spannungswert einer Quelle der vorangehenden Gruppe erhöhten Summe aller Spannungswerte dieser Gruppe entspricht.

12. Vorrichtung nach einem der Ansprüche 3 bis 11 , **dadurch gekennzeichnet,** daß die kleinste Wertigkeit der binären Zahl (BZ) der kleinsten vom Stufenschalter vorgebbaren Spannung ($U_{SV}$) entspricht.

13. Vorrichtung nach einem der vorangegangenen Ansprüche, **dadurch gekennzeichnet,** daß die an der einstellbaren Spannungsquelle (SQ) maximal vorgebbare Spannung der kleinsten vom Stufenschalter vorgebbaren Spannung entspricht.

14. Vorrichtung nach einem der vorangegangenen Ansprüche, **dadurch gekennzeichnet,** daß die einstellbare Spannungsquelle (SQ) aus einer Diodenbrücke (QD1 ... QD4) besteht, bei der ein Transistor (QT) mit linear aussteuerbarer Kollektor-Emitter-Spannung ($U_Q$) im Querzweig (EF) angeordnet ist.

15. Vorrichtung nach einem der vorangegangenen Ansprüche, **dadurch gekennzeichnet,** daß die Schalter des Stufenschalters (STS) ausgeführt sind als zwei antiparallele Transistoren mit je einer in Kollektor-Emitter-Richtung angeordneten Reihendiode.

16. Vorrichtung nach einem der vorangegangenen Ansprüche, **dadurch gekennzeichnet,** daß am Ausgang des Stufenschalters (STS) eine Schutzdiode (FD) in Sperrichtung angeordnet ist.

FIG 1

FIG 2

FIG 3

FIG 4

Europäisches
Patentamt

**EUROPÄISCHER RECHERCHENBERICHT**

Nummer der Anmeldung

EP 87 10 4437

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 084 827 (HAFNER) | | H 02 M 5/458 |
| | | | G 01 N 24/06 |
| | --- | | |
| A,D | GB-A-2 095 940 (SIEMENS) | | |
| | ----- | | |

|  |  |
|---|---|
| | RECHERCHIERTE SACHGEBIETE (Int. Cl.4) |
| | H 02 M |
| | G 01 N |

Der vorliegende Recherchenbericht wurde für alle Patentansprüche erstellt.

| Recherchenort | Abschlußdatum der Recherche | Prüfer |
|---|---|---|
| DEN HAAG | 15-09-1987 | BERTIN M.H.J. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82